(19) Europäisches Patentamt
European Patent Office
Office européen des brevets

(11) Veröffentlichungsnummer: **0 307 828 A2**

# (12) EUROPÄISCHE PATENTANMELDUNG

(21) Anmeldenummer: **88114835.7**

(51) Int. Cl.[4]: **G03F 7/08**

(22) Anmeldetag: **10.09.88**

(30) Priorität: **18.09.87 DE 3731439**

(43) Veröffentlichungstag der Anmeldung:
**22.03.89 Patentblatt 89/12**

(84) Benannte Vertragsstaaten:
**DE FR GB IT NL**

(71) Anmelder: **HOECHST AKTIENGESELLSCHAFT**
**Postfach 80 03 20**
**D-6230 Frankfurt am Main 80(DE)**

(72) Erfinder: **Emmelius, Michael, Dr. Dipl.-Chem.**
**Alfred-Mumbächer-Strasse 30 a**
**D-6500 Mainz(DE)**
Erfinder: **Elsässer, Andreas, Dr. Dipl.-Chem.**
**Hertastrasse 1 b**
**D-6270 Idstein(DE)**
Erfinder: **Mohr, Dieter, Dr. Dipl.-Chem.**
**Eaubonner Strasse 8**
**D-6501 Budenheim(DE)**

## (54) Strahlungsempfindliches Gemisch und hieraus hergestelltes Kopiermaterial.

(57) Die Erfindung betrifft ein strahlungsempfindliches Gemisch, das als wesentlichen Bestandteil ein 1,2-Chinondiazid enthält, das ein Polymeres ist mit wiederkehrenden Einheiten der allgemeinen Formel I

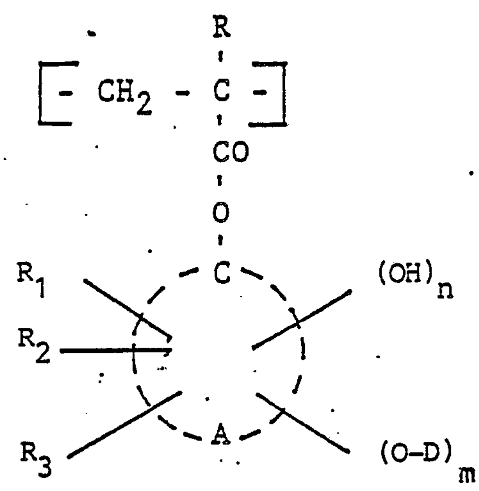

(I)

in der
R ein Wasserstoff- oder Halogenatom, eine Cyanid- oder eine Alkylgruppe,
$R_1$,$R_2$ und $R_3$ gleich oder verschieden sind und Wasserstoff- oder Halogenatome, gegebenenfalls substituierte Alkyl- oder Alkoxygruppen
A die zur Vervollständigung eines ein- oder zweikernigen carbo- oder heterocyclischen aromatischen Ringsystems erforderlichen Atome,
D einen eine 1,2-Chinondiazidgruppierung enthaltenden Rest und

EP 0 307 828 A2

n + m 2 oder 3

bedeuten. Die Erfindung betrifft auch ein hiermit hergestelltes Kopiermaterial. Mit dem Material werden Flachdruckplatten mit großer Druckauflage erzielt.

## Strahlungsempfindliches Gemisch und hieraus hergestelltes Kopiermaterial

Die Erfindung betrifft ein strahlungsempfindliches Gemisch, das als wesentlichen Bestandteil ein 1,2-Chinondiazid enthält, sowie ein hiermit hergestelltes Kopiermaterial.

Positiv arbeitende, strahlungsempfindliche Gemische sind seit langem bekannt und in strahlungsempfindlichen Kopiermaterialien wie Lichtpauspapieren (DE-PS 376 385), Flachdruckplatten (DE-PS 854 890), Farbprüffolien (DE-PS 1 291 197 entsprechend US-PS 3 326 682), Flüssigresists und laminierbaren Trockenresists (DE-OS 2 236 941 entsprechend US-PS 4 093 464) vielfältig anwendbar.

Als 1,2-Chinondiazide werden in diesen Materialien im allgemeinen die Derivate der in DE-PS 865 410 beschriebenen 1,2-Naphthochinondiazidsulfonsäurechloride eingesetzt, z.B. die Ester mit acylierten Phenolen, etwa Trihydroxybenzophenon, wie sie in DE-PS 938 233 entsprechend GB-PS 739 654 aufgeführt sind. Um eine gute Filmbildung zu erreichen, werden diese niedermolekularen Verbindungen mit Phenolharzen - wie in DE-PS 1 195 166 entsprechend US-PS 3 201 239 beschrieben - kombiniert.

Für einige der genannten Anwendungen der Gemische, insbesondere für jene, bei denen die Kopierschichten hohen mechanischen Anforderungen ausgesetzt sind wie im Flachdruck, sind ihre Eigenschaften noch nicht optimal. Im Flachdruck äußert sich dies in einer unbefriedigenden Höhe der Druckauflage.

Zur Verbesserung der mechanischen Schichtfestigkeit ist bekannt, Bindemittel mit höheren Glasübergangstemperaturen einzusetzen, wie etwa Phenolharze auf Naphtholbasis (US-PS 4 551 409), Homo- und Copolymerisate von Vinylphenolen (DE-OS 2 322 230 entsprechend US-PS 3 869 292, DE-OS 3 309 222 entsprechend US-PS 4 439 516 und DE-OS 3 406 927 entsprechend US-PS 4 678 737), Polymerisate von Acrylaten mit freien phenolischen Hydroxygruppen, (JP-OS 76/36 129, EP-A 212 440 und EP-A 212 439) oder Copolymerisate von Hydroxyphenylmaleinimiden (EP-A 0 187 517). Aus der Verwendung dieser Bindemittel in Flachdruckplatten resultiert eine Druckauflagensteigerung. Dieser Verbesserung wirkt allerdings entgegen, daß die eingesetzten lichtempfindlichen 1,2-Chinondiazidverbindungen einen deutlichen Weichmachereffekt auf die Bindemittelmatrix ausüben. Dieser unerwünschte Einfluß kann durch den Einsatz von 1,2-Chinondiazidverbindungen, welche an Polymere chemisch gebunden sind, reduziert werden.

Geeignete Polymersubstrate sind solche, die in den üblicherweise eingesetzten alkalischen Entwicklerlösungen löslich sind. Dies trifft auf freie Carboxylgruppen oder freie phenolische Hydroxylgruppen enthaltende Polymere zu.

Umsetzungsprodukte aus carboxylgruppenhaltigen Polymeren und 1,2-Chinondiazidsulfonsäurechloriden sind bekannt aus DE-OS 2 545 697 und US-PS 4,193,797. Aufgrund der großen Alkalilöslichkeit dieser Verbindungen ist eine Differenzierung zwischen belichteten und unbelichteten Bereichen jedoch schlecht, so daß diese Verbindungen keine praktische Anwendung gefunden haben.

Auch Polymere mit freien phenolischen Hydroxylgruppen sind bekannt (US-PS 3 635 709). Sie erhält man durch Veresterung von 1,2-Naphthochinondiazid-sulfonsäurechloriden mit Pyrogallol-Aceton-Harz. Da es sich bei dem eingesetzten Harz um ein relativ niedermolekulares Produkt handelt (Molekulargewicht unter 2000), ist die Druckauflagensteigerung nicht sehr groß.

Aus DE-OS 2 507 548 entsprechend US-PS 4 139 384 sind polymere 1,2-Chinondiazidverbindungen bekannt, welche man durch Veresterung mit Polyhydroxystyrolen erhält. Bei diesen Diaziden handelt es sich zwar um hochpolymere Verbindungen, jedoch ist deren Löslichkeit in alkalischen Entwicklern ebenfalls groß. Man hat versucht, dem abzuhelfen, indem man einen Teil der phenolischen Hydroxylgruppen mit Epoxiden umgesetzt hat; dies bedeutet aber zusätzlich synthetischen Aufwand.

Aus der japanischen Offenlegungsschrift 76/39 024 sind 1,2-Chinondiazidverbindungen bekannt, welche an Polymere auf Basis von Hydrochinon- und Dihydroxynaphthalinmono(meth)acrylaten gebunden sind. Auch diese Verbindungen haben keine praktische Anwendung gefunden.

Es war Aufgabe der Erfindung ein positiv arbeitendes strahlungsempfindliches Gemisch auf Basis von 1,2-Chinondiazidverbindungen und ein hiermit hergestelltes lichtempfindliches Kopiermaterial bereitzustellen, das Flachdruckplatten mit höheren Druckauflagen als sie mit herkömmlichen Gemischen erreichbar sind, ergibt.

Die Lösung dieser Aufgabe geht aus von einem strahlungsempfindlichen Gemisch, das als wesentlichen Bestandteil ein 1,2-Chinondiazid enthält, und sie ist dadurch gekennzeichnet, daß das 1,2-Chinondiazid ein Polymeres ist mit wiederkehrenden Einheiten der allgemeinen Formel I

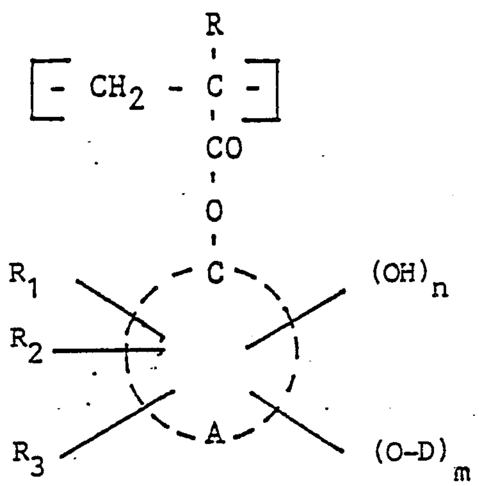

(I)

in der

R ein Wasserstoff- oder Halogenatom, eine Cyanid- oder eine Alkylgruppe,

$R_1$, $R_2$ und $R_3$ gleich oder verschieden sind und Wasserstoff- oder Halogenatome, Alkyl- oder Alkoxygruppen,

A die zur Vervollständigung eines ein- oder zweikernigen carbo- oder heterocyclischen aromatischen Ringsystems erforderlichen Atome,

D einen eine 1,2-Chinondiazidgruppierung enthaltenden Rest und

n + m 2 oder 3

bedeuten.

Im Falle, daß R eine Alkylgruppe ist, enthält diese im allgemeinen 1 bis 6, bevorzugt 1 oder 2 Kohlenstoffatome. Besonders bevorzugt werden Verbindungen, in denen R ein Wasserstoffatom oder die Methylgruppe bedeutet.

Von den Substituenten $R_1$, $R_2$ und $R_3$ ist vorteilhaft einer ein Wasserstoffatom, vorzugsweise sind mindestens zwei Wasserstoffatome. Wenn diese Symbole Alkyl- oder Alkoxygruppen bedeuten, haben diese in der Regel 1 bis 6, insbesondere 1 bis 3 Kohlenstoffatome.

Allgemein sind hier unter Alkylgruppen verzweigte und unverzweigte, gesättigte und ungesättigte Gruppen mit cyclischen und offenen Ketten zu verstehen, die durch Halogenatome oder Hydroxygruppen substituiert sein oder Ether- oder Ketogruppen enthalten können. Bevorzugt werden unverzweigte Alkylgruppen mit 1 bis 3 Kohlenstoffatomen.

Das carbo- oder heterocyclische aromatische Ringsystem A kann ein- oder mehrkernig sein. Unter den carbocyclischen Ringsystemen sind Benzol-, Naphthalin- und Biphenyl-, unter den heterocyclischen Pyridin-, Pyrimidin-, Pyrazin-, Chinolin-, Chinoxalin-, Indol-, oder Thiophen-Systeme zu nennen. Ein carbocyclisches Ringsystem ist bevorzugt. Insbesondere ist A ein Benzolring.

D ist bevorzugt ein aromatischer, gegebenenfalls substituierter 1,2-Chinondiazidrest. D ist insbesondere ein 1,2-Naphthochinon-2-diazid-4- oder -5-sulfonylrest.

Die Summe aus n und m ist vorzugsweise 2, wobei es sich bei n und m nicht um ganze Zahlen handeln muß, da sie sich auf das Gesamtpolymermolekül beziehen. Der Veresterungsgrad m/n+m ist vorzugsweise kleiner als 0,7.

Die Position der beschriebenen Substituenten am Ringsystem A unterliegt keinerlei Beschränkungen, sie richtet sich lediglich nach der präparativen Zugänglichkeit der Verbindungen.

Weiterhin können die erfindungsgemäßen polymeren 1,2-Chinondiazide Einheiten enthalten, welche durch wiederkehrende Einheiten der allgemeinen Formel II wiedergegeben werden

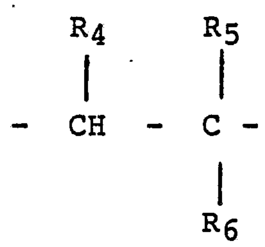 (II)

worin

$R_4$ ein Wasserstoffatom oder eine Carboxylgruppe, die mit $R_5$, wenn letzteres eine Carboxylgruppe ist, zu einem Säureanhydrid verbunden sein kann,

$R_5$ eine Alkyl-, Alkoxy-, Alkoxycarbonyl-, Acyl-, Acyloxy-, Aryl-, Formyl-, Cyanid-, Carboxyl-, Hydroxyl- oder Aminocarbonylgruppe und

$R_6$ ein Wasserstoff- oder Halogenatom oder eine Alkylgruppe

bedeuten.

Wenn $R_5$ oder $R_6$ Alkylgruppen sind, haben diese im allgemeinen 1 - 4 Kohlenstoffatome. Als Vertreter für $R_5$ kommen in Betracht: Alkoxygruppen mit 1 - 8 Kohlenstoffatomen, Alkoxycarbonylgruppen mit 2 - 13 Kohlenstoffatomen, Acylgruppen mit 2 - 20 Kohlenstoffatomen, Acyloxygruppen mit 2 - 18 Kohlenstoffatomen und Arylgruppen mit 6 - 10 Kohlenstoffatomen. Die Aminocarbonylgruppen können mit 1 - 8 Kohlenstoffatomen substituiert sein.

Die erfindungsgemäßen Verbindungen werden durch Veresterung der entsprechenden 1,2-Chinondiazidsäurechloride mit den Hydroxylgruppen der zugrunde liegenden Polymeren nach den in der Literatur bekannten Verfahren (US-PS 3 635 709 oder DE-OS 2 507 548) erhalten. Die Herstellung der polymeren Ausgangsverbindungen und der zugrunde liegenden Monomeren ist bekannt (EP-A-0 212 439 und DE-OS 35 28 928).

Bevorzugt unter den polymeren Ausgangsverbindungen sind Homo- und Copolymere des Pyrogallolmonomethacrylates, wobei das Molekulargewicht dieser Polymeren in weiten Grenzen schwanken kann. Vorzugsweise werden Polymerisate mit einem Molekulargewicht von 5000 bis 100.000 eingesetzt. Die Hydroxylzahl der Polymeren liegt vorzugsweise zwischen 200 und 500.

Die Auswahl von geeigneten Polymeren richtet sich im Einzelfall nach der Anwendung und nach der Art der übrigen Komponenten in dem Gemisch bzw. der Kopierschicht.

Zur Herstellung der erfindungsgemäßen Gemische werden die 1,2-Chinondiazidverbindungen vorteilhaft kombiniert mit einem in Wasser unlöslichen, in wäßrig-alkalischen Lösungen löslichen oder zumindest quellbaren Bindemittel.

Beispielsweise seien als Bindemittel genannt: Phenol-oder Kresol-Formaldehydharze, besonders Novolake, welche auch in bekannter Weise durch Umsetzung mit Epoxiden, Chloressigsäure, Isocyanaten, etc. modifiziert sein können. Des weiteren eignen sich Homo- und Copolymerisate von Vinylphenolen, Polymerisate von Acrylaten mit freien phenolischen Hydroxylgruppen, ferner Copolymerisate von Hydroxyphenylmaleinimiden. Sie werden im allgemeinen in Mengen von etwa 30 bis 90 Gewichtsprozent, bezogen auf das Gewicht des Gemisches eingesetzt.

Es ist auch möglich, auf den Zusatz von Bindemitteln zu verzichten. Dies ist beispielsweise dann der Fall, wenn der Veresterungsgrad, d.h. der Wert m/m+n der eingesetzten 1,2-Chinondiazidverbindungen, relativ klein ist.

Weiterhin können in dem strahlungsempfindlichen Gemisch noch zahlreiche andere Harze mitverwendet werden, die entweder wasserlöslich oder aber alkaliunlöslich sein können. Hierher gehören Vinylpolymerisate wie Polyvinylacetat, Polyvinylacetale, Polyacrylate, Polyvinylether oder Polyvinylpyrrolidone, die durch Comonomere modifiziert sein können. Der günstigste Anteil an diesen Har zen richtet sich nach den anwendungstechnischen Erfordernissen und nach dem Einfluß auf die Entwicklungsbedingungen. Er beträgt im allgemeinen nicht mehr als 20 Gewichtsprozent vom alkalilöslichen Harz.

In geringen Mengen kann die lichtempfindliche Schicht für spezielle Erfordernisse wie Flexibilität, Haftung, Glanz etc., außerdem noch Substanzen wie Polyglykole, Celluloseether, wie Ethylcellulose, Netzmittel, Farbstoffe und feinteilige Pigmente enthalten. Schließlich können dem strahlungsempfindlichen Gemisch noch lösliche oder auch feinteilige dispergierbare Farbstoffe sowie, je nach Anwendungszweck, auch UV-Absorber zugesetzt werden. Als Farbstoffe haben sich die Triphenylmethanfarbstoffe,insbesondere in der Form ihrer Carbinolbasen, bewährt. Die günstigsten Mengenverhältnisse der Komponenten lassen sich im Einzelfall durch Vorversuche leicht ermitteln.

Die Erfindung betrifft auch ein strahlungsempfindliches Kopiermaterial aus einem Schichtträger und

einem aufgebrachten strahlungsempfindlichen Gemisch. Es ist dadurch gekennzeichnet, daß das Gemisch ein 1,2-Chinondiazid nach den Ansprüchen 1 bis 4 enthält.

Zur Beschichtung des Schichtträgers werden die Schichtbestandteile im allgemeinen in einem Lösungsmittel gelöst. Die Wahl des Lösungsmittels richtet sich nach dem Beschichtungsverfahren, der Schichtdicke und den Trocknungsbedingungen. Geeignet sind prinzipiell alle Lö sungsmittel, die mit den Schichtbestandteilen verträglich sind, wie Alkohole, Ketone, Ester, chlorierte Kohlenwaserstoffe etc. Bevorzugt werden Gemische mit Glykolethern.

Als Schichtträger für die strahlungsempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhte und gegebenenfalls anodisiertes Aluminium, Siebdruckschablonenträger, Holz, Keramik, Glas und Silicium, dessen Oberfläche chemisch beispielsweise in Siliciumnitrid oder Siliciumdioxid umgewandelt sein kann, genannt.

Bevorzugte Schichtträger für dicke Schichten über 0,01 mm sind Kunststoffolien, die dann als temporäre Träger für Transferschichten dienen. Dafür und für Farbfolien werden Polyesterfolien, zum Beispiel aus Polyethylenterephthalat, bevorzugt. Polyolefinfolien, wie Polypropylen, sind jedoch ebenfalls geeignet. Als Schichtträger für Schichtdicken unter ca. 0,01 mm werden meist Metalle verwendet.

Für Offsetdruckplatten können eingesetzt werden: mechanisch oder chemisch aufgerauhtes und gegebenenfalls anodisiertes Aluminium, das zudem noch chemisch, zum Beispiel mit Polyvinylphosphonsäure, Silikaten oder Phosphaten, vorbehandelt sein kann.

Schließlich kann die Beschichtung direkt oder durch Schichtübertragung vom temporären Träger erfolgen auf Leiterplattenmaterialien, die aus Isolierplatten mit ein- oder beideitiger Kupferauflage bestehen, auf Glas oder Keramikmaterialien, die gegebenenfalls oberflächlich haftvermittelnd vorbehandelt sind, und auf Siliciumscheiben.

Für die Trocknung nach der Beschichtung können die üblichen Geräte und Bedingungen übernommen werden, Temperaturen um 100 °C und kurzfristig bis 120 °C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden. Mit Vorteil werden Laserbestrahlungsgeräte, insbesondere automatische Verarbeitungsanlagen verwendet, die als Strahlungsquelle einen Argonionen-Laser enthalten. Die Bestrahlung kann auch mit Elektronenstrahlen erfolgen. Röntgen-oder Ionenstrahlen können ebenfalls zur Bilderzeugung verwendet werden.

Die bildmäßg bestrahlte oder belichtete Schicht kann in bekannter Weise mit den für handelsübliche Naphthochinondiazid-Schichten und Kopierlacke bekannten Entwicklern behandelt werden. Die erfindungsgemäßen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können zum Beispiel Alkali-phosphate, -silikate, -borate oder -hydroxide, ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwikkelten Platten kurzzeitig auf erhöhte Temperaturen erwärmt werden, wie es für Diazoschichten aus der GB-PS 1 154 749 bekannt ist.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Synthesebeipiel 1

60,5 g 1,2-Naphthochinon-2-diazid-5-sulfonylchlorid und 181 g eines Copolymeren aus Styrol und Pyrogallolmonomethacrylat mit einem mittleren Molekulargewicht von 23.000 und einer Hydroxylzahl von 338 werden in 1 kg Tetrahydrofuran gelöst. Unter Rühren tropft man 23 g Triethylamin innerhalb einer Stunde zu, wobei man durch Kühlung die Temperatur bei 25 °C hält. Nach beendeter Zugabe rührt man

noch 2 Stunden weiter. Dann wird die gesamte Reaktionslösung in 20 kg 4%ige Salzsäure gegeben. Der Niederschlag wird abfiltriert, gründlich mit $H_2O$ gewaschen und bei 40° C und 53,2 • $10^2$ Pa (40 Torr) bis zur Gewichtskonstanz getrocknet. Aus dem Schwefelgehalt des Polymeren errechnet sich ein Veresterungsgrad von

$$\frac{m}{n+m} = 0,206$$

Synthesebeispiel 2

Entsprechend Synthesebeispiel 1 wird eine polymere 1,2-Chinondiazidverbindung hergestellt, wobei jedoch anstelle des 1,2-Naphthochinon-(2)-diazid-5-sulfonylchlorids das 1,2-Naphthochinon-2-diazid-4-sulfonylchlorid eingesetzt wird. Das Produkt besitzt einen Veresterungsgrad von 0,204.

Synthesebeispiel 3

Entsprechend Synthesebeispiel 1 wird eine polymere 1,2-Chinondiazidverbindung hergestellt, wobei jedoch als Poly mersubstrat 195 g eines Copolymeren aus Methylmethacrylat und Pyrogallolmonomethacrylat mit einem mittleren Molekulargewicht von 21.000 und einer Hydroxylzahl von 432 eingesetzt werden. Das Produkt besitzt einen Veresterungsgrad von 0,15.

Beispiel 1

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:
2,0 Gt der unter Synthesebeispiel 1 beschriebenen Verbindung
6,0 Gt Kresol-Formaldehyd-Novolak (Schmelzpunkt - nach Kapillarmethode DIN 53 181 - 105-120° C) und
0,2 Gt 1,2-Naphthochinon-2-diazid-4-sulfonylchlorid
0,08 Gt Kristallviolett
91,72 Gt eines Lösungsmittelgemisches aus Tetrahydrofuran, Propylenglykolmonomethylether, Butylacetat im Gewichtsverhältnis von 2 : 2 : 1
Nach zwei Minuten Trocknen bei 100° C resultiert eine Schichtdicke von 2 µm.

Als Vergleichsbeispiel wird auf dieselbe Art und Weise eine Flachdruckplatte hergestellt, wobei jedoch anstelle der nach Synthesebeispiel 1 erhaltenen Verbindung
2,0 Gt eines Veresterungsproduktes aus 3 Mol 1,2-Naphthochinon-2-diazid-5-sulfonylchlorid und 1 Mol 2,3,4-Trihydroxybenzophenon
eingesetzt werden.

Die Druckplatten werden durch ein Diapositiv unter einer 5 kW-Metallhalogenidlampe im Abstand von 110 cm 60 Sekunden lang belichtet und in einem Entwickler folgender Zusammensetzung
8,5 Gt $Na_2SiO_3$ x 9 $H_2O$,
0,8 Gt NaOH und
1,5 Gt $Na_2B_4O_7$ x 10 $H_2O$ in
89,2 Gt $H_2O$
entwickelt, wodurch die belichteten Schichtbereiche entfernt werden.

Ein Druckversuch mit den so hergestellten Offsetdruckformen erbrachte für die erfindungsgemäße Ausführung eine Auflagenleistung von 130.000 Drucken, während die zum Vergleich hergestellte Druckform bereits nach 100.000 Drucken merkliche Schäden aufwies.

Beispiel 2

Eine in Salpetersäure elektrolytisch aufgerauhte, in Schwefelsäure anodisierte und mit Polyvinylphosphonsäure hydrophilierte Aluminiumplatte wird mit folgender Lösung schleuderbeschichtet:

2,0 Gt der unter Synthesebeispiel 2 beschriebenen Verbindung
5,9 Gt des Novolaks aus Beispiel 1
0,1 Gt eines Novolaks aus Phenol und t-Butyl-Phenol mit einem Schmelzpunkt von 110-120 °C nach DIN 53 736
0,2 Gt 1,2-Naphthochinon-(2)-diazid-4-sulfonylchlorid
0,06 Gt Kristallviolett
0,02 Gt Sudangelb GGN
91,72 Gt des Lösungsmittelgemisches aus Beispiel 1

Nach Trocknung resultiert eine Schichtdicke von 2µm. Ebenso wird eine Vergleichsplatte hergestellt, bei der anstelle der unter Synthesebeispiel 2 beschriebenen Verbindung 2,0 Gt des Veresterungspoduktes aus 1 Mol p-Cumylphenol und 1 Mol 1,2-Naphthochinon-(2)-diazid-4-sulfonylchlorid eingesetzt werden.

Die Druckplatten werden wie in Beispiel 1 belichtet und entwickelt. Ein Druckversuch mit den so hergestellten Offsetdruckformen erbrachte für die erfindungsgemäße Ausführung eine Auflagenleistung von 180.000 Drucken, während die Vergleichsplatte nach 130.000 Drucken abgelaufen war.

Beispiel 3

Eine in Salpetersäure elektrolytisch aufgerauhte, in Schwefelsäure anodisierte und mit Polyvinylphosphonsäure hydrophilierte Aluminiumplatte wird mit folgender Lösung schleuderbeschichtet:

8,0 Gt der unter Synthesebeispiel 3 beschriebenen Verbindung
0,2 Gt 2-(4-Styrylphenyl)-4,6-bis-trichlormethyl-s-triazin
0,05 Gt Kristallviolett
0,03 Gt Viktoriareinblau
91,72 Gt des Lösungsmittelgemisches aus Beispiel 1

Nach Trocknen resultiert eine Schichtdicke von 2,3 µm. Die Druckplatten werden wie in Beispiel 1 belichtet und mit einem 50 : 50-Gemisch aus $H_2O$ und dem Entwickler aus Beispiel 1 entwickelt.

Ein Druckversuch mit den so hergestellten Offsetdruckformen erbrachte eine Auflagenleistung von 170.000 Drucken.

Beispiel 4

Entsprechend Beispiel 1 werden Druckplatten hergestellt, wobei jedoch anstelle des Kresol-Formaldehyd-Novolaks folgende Bindemittel eingesetzt werde:

a Ein Copolymer aus 4-Hydroxystyrol und Styrol mit einer Hydroxylzahl von 250 und einem Molekulargewicht von 22.000.

b Ein Terpolymer aus 4-Hydroxystyrol, Styrol und N-Methoxymethylmethacrylamid (50:35:15) mit einer Hydroxylzahl von 237 und einem Molekulargewicht von 23.000.

c Ein Copolymer aus Brenzkatechinmonomethacrylat und Styrol (70:30) mit einer Hydroxylzahl von 230 und einem Molekulargewicht von 19.500.

d Ein Terpolymer aus Brenzkatechinmonomethacrylat, Styrol und N-Methoxymethylmethacrylamid (70:15:15) mit einer Hydroxylzahl von 235 und einem Molekulargewicht von 20.500.

Die Schichtdicken werden einheitlich auf 2 µm eingestellt. Nach Belichten und Entwickeln der Druckplatten wie in Beispiel 1 beschrieben wird die jeweilige Druckauflage bestimmt zu: a) 150 000, b) 140 000, c) 160 000 und d) 150 000.

**Ansprüche**

1. Strahlungsempfindliches Gemisch, das als wesentlichen Bestandteil ein 1,2-Chinondiazid enthält, dadurch gekennzeichnet, daß das 1,2-Chinondiazid ein Polymeres ist mit wiederkehrenden Einheiten der allgemeinen Formel I

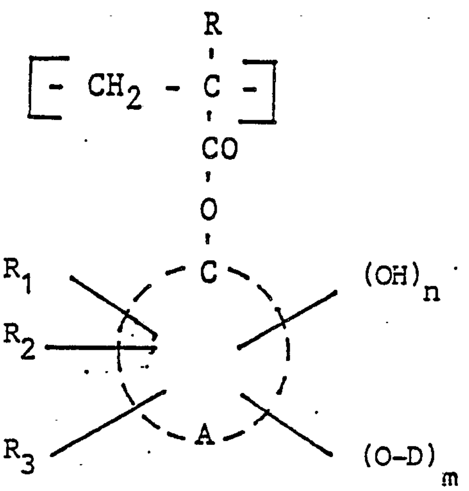

(I)

in der

R ein Wasserstoff- oder Halogenatom, eine Cyanid- oder eine Alkylgruppe,

$R_1$,$R_2$ und $R_3$ gleich oder verschieden sind und Wasserstoff- oder Halogenatome, gegebenenfalls substituierte Alkyl- oder Alkoxygruppen

A die zur Vervollständigung eines ein- oder zweikernigen carbo- oder heterocyclischen aromatischen Ringsystems erforderlichen Atome,

D einen eine 1,2-Chinondiazidgruppierung enthaltenden Rest und

n + m 2 oder 3

bedeuten.

2. Gemisch nach Anspruch 1, dadurch gekennzeichnet, daß

R Wasserstoff oder eine Alkylgruppe mit 1 bis 6 Kohlenstoffatomen,

$R_1$, $R_2$ und $R_3$ Wasserstoff, gegebenenfalls substituierte Alkyl- oder Alkoxygruppen mit 1 bis 6 Kohlenstoffatomen,

A ein carbocyclisches Ringsystem,

D ein 1,2-Naphthochinon-2-diazid-4- oder -5-sulfonylrest und

n + m 2

bedeuten.

3. Gemisch nach Anspruch 1, dadurch gekennzeichnet, daß das 1,2-Chinondiazid ferner wiederkehrende Einheiten der allgemeinen Formel II

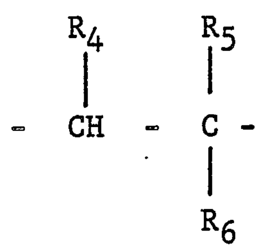

(II)

enthält, worin

$R_4$ ein Wasserstoffatom oder eine Carboxylgruppe, die mit $R_5$, wenn letzteres eine Carboxylgruppe ist, zu einem Säureanhydrid verbunden sein kann,

$R_5$ eine Alkyl-, Alkoxy-, Alkoxycarbonyl-, Acyl-, Acyloxy-, Aryl-, Formyl-, Cyanid-, Carboxyl-, Hydroxyl- oder Aminocarbonylgruppe und

$R_6$ ein Wasserstoff- oder Halogenatom oder eine Alkylgruppe

bedeuten.

4. Gemisch nach Anspruch 3, dadurch gekennzeichnet, daß

$R_5$ eine Alkylgruppe bis 1 - 4 Kohlenstoffatomen, eine Alkoxygruppe mit 1 - 8 Kohlenstoffatomen, eine Alkoxycarbonylgruppe mit 2 - 13 Kohlenstoffatomen, eine Acylgruppe mit 2 - 20 Kohlenstoffatomen, eine

Acyloxygruppe mit 2 - 18 Kohlenstoffatomen oder eine Arylgruppe mit 6 - 10 Kohlenstoffatomen und
$R_6$ eine Alkylgruppe mit 1 - 4 Kohlenstoffatomen
bedeuten.

5. Gemisch nach Ansprüchen 1 bis 4, dadurch gekennzeichnet, daß es ein in Wasser unlösliches, in wäßrigalkalischen Lösungen lösliches oder zumindest quellbares Bindemittel enthält.

6. Strahlungsempfindliches Gemisch nach Anspruch 5, dadurch gekennzeichnet, daß das Bindemittel ein Novolak ist.

7. Strahlungsempfindliches Kopiermaterial aus einem Schichtträger und einem aufgebrachten strahlungsempfindlichen Gemisch, dadurch gekennzeichnet, daß das Gemisch ein 1,2-Chinondiazid nach den Ansprüchen 1 bis 4 enthält.